# EUROPÄISCHE PATENTANMELDUNG

(11) **EP 1 768 259 A1**
(43) Veröffentlichungstag der Anmeldung: **28.03.2007**
(21) Anmeldenummer: 06017949.6
(22) Anmeldetag: 29.08.2006
(51) Int. Cl.: H03K 17/968

(54) **Optische Schaltvorrichtung geeignet zur Verwendung in Kraftfahrzeugen**

(30) Priorität: 21.09.2005 DE 102005045865
(71) Anmelder: Valeo Schalter und Sensoren GmbH, 74321 Bietigheim-Bissingen (DE)
(72) Erfinder: Müller, Stefan, 74182 Obersulm (DE); Klein, Rudolf, 74348 Lauffen a.N. (DE)
(74) Vertreter: Thielking, Klaus

(57) **Zusammenfassung**

Die Erfindung betrifft eine Schaltvorrichtung (10), insbesondere zur Verwendung in Kraftfahrzeugen, mit einem bewegbaren Betätigungselement (12), wobei die Schaltvorrichtung zur Erfassung von Schaltstellungen des Betätigungselements (12) eine Lichtquelle (28) und eine zugeordnete Lichtempfangseinrichtung (42) aufweist, wobei die Lichtquelle (28) mit dem Betätigungselement (12) bewegungsgekoppelt ist und wobei die Lichtempfangseinrichtung (42) mindestens ein Empfangselement aufweist, das ein von dem zugeführten Lichtstrom abhängiges, analoges Ausgangssignal erzeugt.

## Beschreibung

Die Erfindung betrifft eine Schaltvorrichtung, insbesondere zur Verwendung in Kraftfahrzeugen, mit einem bewegbaren Betätigungselement, wobei die Schaltvorrichtung zur Erfassung von Schaltstellungen des Betätigungselements eine Lichtquelle und eine zugeordnete Lichtempfangseinrichtung aufweist.

Solche Schaltvorrichtungen sind beispielsweise aus der DE 197 35 476 A1 und aus der DE 197 54 192 A1 bekannt. Mit den Schaltvorrichtungen können die Schaltstellungen des Betätigungselements mit Hilfe optischer Elemente erfasst werden.

Bei der aus der DE 197 54 192 A1 bekannten Vorrichtung wird Licht aus einer ortsfesten Lichtquelle in Lichtleiter übertragen, die in dem bewegbaren Betätigungselement angeordnet sind. Das aus der Lichtquelle in die Lichtleiter eingespeiste Licht kann am Ende des Lichtleiters ausgekoppelt werden, um auf eine Lichtempfangseinrichtung zu treffen. Die Lichtempfangseinrichtung ist als zweidimensionale Sensormatrix ausgebildet, so dass das aus dem Lichtleiter ausgekoppelte Licht bei verschiedenen Stellungen des Betätigungselements auf verschiedene Bereiche der Sensormatrix treffen kann.

Mit der aus der DE 197 54 192 A1 bekannten Vorrichtung können auf eng begrenztem Bauraum mit hoher Genauigkeit eine Vielzahl von Schaltstellungen des Betätigungselements erfasst werden. Der vorliegenden Erfindung liegt hiervon ausgehend die Aufgabe zugrunde, unter Beibehaltung eines hohen Auflösungsvermögens eine möglichst einfach bauende Schaltvorrichtungen zu schaffen.

Diese Aufgabe wird erfindungsgemäß dadurch gelöst, dass die Lichtquelle mit dem Betätigungselement bewegungsgekoppelt ist und dass die Lichtempfangseinrichtung mindestens ein Empfangselement aufweist, das ein von dem zugeführten Lichtstrom abhängiges analoges Ausgangssignal erzeugt.

Die Lichtquelle ist also in Abweichung vom Stand der Technik nicht ortsfest, sondern mit der Bewegung des Betätigungselements gekoppelt. Hierdurch kann eine optische Schnittstelle zwischen einem ortsfesten Bereich und dem Betätigungselement entfallen. Hierdurch sind Lichtleistungsverluste minimiert. Weiterhin ist die Vorrichtung weniger anfällig für eine Änderung der optischen Eigenschaften aufgrund von Schmutz und/oder Alterung.

Dadurch, dass die Lichtempfangseinrichtung mindestens ein Empfangselement aufweist, das ein von dem zugeführten Lichtstrom abhängiges, analoges Ausgangssignal erzeugt, kann gegenüber einer zweidimensionalen Sensormatrix einfacher aufgebautes Empfangselement, beispielsweise eine Fotodiode verwendet werden. Da dieses Empfangselement ein analoges Ausgangssignal erzeugt, wird nicht nur eine Information darüber gewonnen, ob das Empfangselement Licht empfängt oder nicht (digitales Ausgangssignal), sondern auch darüber, wie hoch der zugeführte Lichtstrom ist. Somit kann die Lichtquelle, die mit dem Betätigungselement bewegungsgekoppelt ist, diesem Empfangselement einen Lichtstrom zuführen, wobei bestimmte Lichtströme mit bestimmten Schaltstellungen des Betätigungselements korrespondieren.

Die Schaltvorrichtung zeichnet sich durch einen besonders einfachen und robusten Aufbau aus und dadurch, dass trotz sehr einfacher Bauelemente ein hohes Auflösungsvermögen erreicht werden kann.

Die Lichtquelle kann an oder in dem Betätigungselement angeordnet sein. Hierdurch kann ein kompakter und weiter vereinfachter Aufbau geschaffen werden. Die elektrische Kontaktierung der Lichtquelle kann beispielsweise über eine Kabelverbindung oder über Schleifkontakte erfolgen. Diese Kontaktierung dient aber lediglich der Stromversorgung der Lichtquelle. Somit können die grundsätzlichen Vorteile, die durch Verwendung von optischen Elementen entstehen, beibehalten werden, gleichzeitig jedoch eine besonders unempfindliche Anordnung geschaffen werden, da der Weg, den das Licht von der Lichtquelle zu der Lichtempfangseinrichtung zurücklegen muss, weniger optische Schnittstellen aufweist.

Eine Ausführungsform der Erfindung sieht vor, dass die Lichtquelle benachbart zu einer Lagerstelle des Betätigungselements angeordnet ist. Dies hat den Vorteil, dass die elektrische Kontaktierung der Lichtquelle in einem Bereich erfolgen kann, der bei Bewegung des Betätigungselements keine oder nur sehr kleine Bewegungswege erfährt. Hierdurch kann die elektrische Kontaktierung der Lichtquelle entsprechend einfacher aufgebaut sein.

Nach einer besonders bevorzugten Ausführungsform speist die Lichtquelle Licht in einen Lichtleiter, der mit dem Betätigungselement bewegungsgekoppelt ist. Hierdurch ist es möglich, die Lichtquelle und die Lichtempfangseinrichtung frei zueinander zu positionieren. Diese Freiheiten werden bei Verwendung von gekrümmten Lichtleitern weiter erhöht.

Die Lichtquelle kann auch an oder in dem mindestens einen Empfangselement zugewandten Endbereich des Betätigungselements angeordnet sein. Mit einer solchen Anordnung kann der Weg, den das Licht von der Lichtquelle zu der Lichtempfangseinrichtung zurücklegen muss, auf ein Minimum reduziert werden. Hierdurch kann auch eine vergleichsweise lichtschwache Lichtquelle verwendet werden oder die Lichtquelle kann so betrieben werden, dass sie eine sehr hohe Lebensdauer hat.

Eine weitere vorteilhafte Ausführungsform der Erfindung sieht vor, dass mehrere Empfangselemente mit einer gemeinsamen Auswerteeinheit gekoppelt sind, die die Ausgangssignale der Empfangselemente für eine Bestimmung der Schaltstellung des Betätigungselements auswertet. Durch die Verwendung mehrerer Empfangselemente kann die Auflösung, mit der Schaltstellungen erfasst werden können, erhöht werden. Gleichzeitig kann eine redundante Schaltvorrichtung geschaffen werden, wenn die Auswerteeinheit die Ausgangssignale der Empfangselemente einer Plausibilitätsprüfung unterzieht. Wenn das Betätigungselement beispielsweise ausgehend von einer äußeren Ausgangsstellung an zwei zueinander benachbarten Empfangselementen vorbeigeführt wird, erfasst zunächst ein erstes Empfangselement einen bis auf ein Maximum ansteigenden Lichtstrom und wandelt diesen in entsprechende analoge Ausgangssignale um. Bei weiterer Bewegung des Betätigungselements nimmt der zugeführte Lichtstrom ab, wobei gleichzeitig dem zweiten Empfangselement ein ansteigender Lichtstrom zugeführt wird. Dieser Lichtstrom steigt wiederum bis auf ein Maximum an und fällt danach, sofern es der Bewegungsweg des Betätigungselements erlaubt, wiederum ab. Eine Schaltstellung, die einer Stellung des Betätigungselements zwischen den Empfangselementen zugeordnet ist, korrespondiert also mit einem entsprechenden Signalverlauf von mehreren Empfangselementen. Hierdurch ist es möglich zu prüfen, ob die Ausgangssignale eines Empfangselements plausibel sind.

Weitere Vorteile, Merkmale und Einzelheiten der Erfindung ergeben sich aus der nachfolgenden Beschreibung, in der unter Bezugnahme auf die Zeichnung ein besonders bevorzugtes Ausführungsbeispiel im Einzelnen beschrieben ist. Dabei können die in der Zeichnung gezeigten sowie in den Ansprüchen sowie in der Beschreibung erwähnten Merkmale jeweils einzeln für sich oder in beliebiger Kombination erfindungswesentlich sein.

In der Zeichnung zeigen:
- Figur 1: eine geschnittene Seitenansicht einer erfindungsgemäßen Schaltvorrichtung, mit einer Lichtquelle, einem Lichtleiter und einer Lichtempfangseinrichtung; und
- Figur 2: eine schematische Darstellung der Anordnung von Lichtquelle, Lichtleiter und Empfangselementen der Lichtempfangseinrichtung.

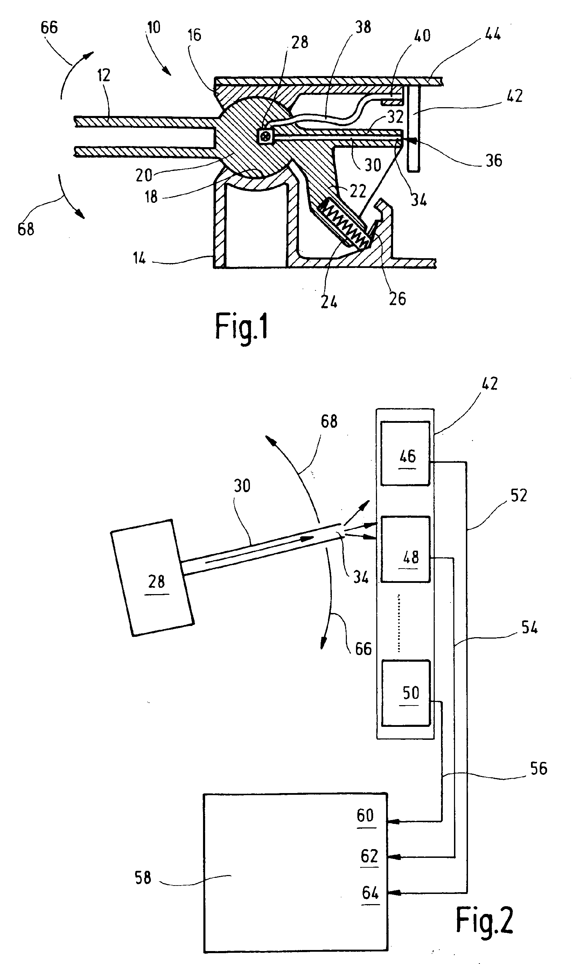

In Figur 1 ist eine Schaltvorrichtung insgesamt mit dem Bezugszeichen 10 bezeichnet. Diese weist ein längliches Betätigungselement 12 auf, das beispielsweise als Lenkstockschalter (beispielsweise Blinkerhebel oder Wischerhebel), als Schaltermodul, Schalthebel, Einzelschalter, Vier-Quadranten-Schalter, Wippenschalter oder Gangwahlhebel ausgebildet sein kann. Das Betätigungselement 12 ist zwischen zwei fahrzeugfesten Gehäuseteilen 14 und 16 gelagert. Die Gehäuseteile weisen eine Lagerstelle 18 auf, in der eine kugelförmige Erweiterung 20 des Betätigungselements 12 gelagert ist. Benachbart zur kugelförmigen Erweiterung 20 weist das Betätigungselement 12 einen Arm 22 auf, der endseitig mit einem federbelasteten Stößel 24 versehen ist. Der Stößel 24 greift in eine an dem ersten Gehäuseteil 14 ausgebildete Steuerkurve 26, so dass das Betätigungselement 12 zwangsgeführt ist.

In der kugelförmigen Erweiterung 20 ist eine Lichtquelle 28 angeordnet, die in nicht näher dargestellter Weise elektrisch kontaktiert ist, beispielsweise über eine Kabelverbindung und/oder über Schleifkontakte. Die Lichtquelle speist einen starren Lichtleiter 30, der in einer länglichen Lichtleiteraufnahme des Betätigungselements 12 gelagert ist. Der Lichtleiter 30 weist auf seiner der Lichtquelle 28 abgewandten Seite ein Auskoppelende 34 auf, das in einem Endbereich 36 des Betätigungselements 12 angeordnet ist.

Die Lichtquelle 28 speist ferner einen flexiblen Lichtleiter 38 mit Licht, das ein von der Lichtquelle 28 beabstandetes Auskoppelende 40 aufweist, das an dem zweiten Gehäuseteil 16 festgelegt ist.

Die Auskoppelenden 34 und 40 der Lichtleiter 30 und 38 weisen auf eine insgesamt mit 42 bezeichnete, schematisch dargestellte Lichtempfangseinrichtung. Diese ist an einer Leiterplatte 44 angeordnet, die an dem zweiten Gehäuseteil 16 befestigt ist.

Mit Bezug auf Figur 2 weist die Lichtempfangseinrichtung 42 mehrere Empfangselemente auf, von denen in Figur 2 beispielhaft drei Empfangselemente 46, 48 und 50 dargestellt sind. Die Empfangselemente 46 bis 50 stehen über jeweils einzelnen Empfangselementen zugeordneten Datenleitungen 52 bis 56 mit einer gemeinsamen Auswerteeinheit 58 in Verbindung. An den Datenleitungen 52 bis 56 liegen die jeweiligen Ausgangssignale 60 bis 64 der Empfangselemente 46 bis 50 an. Diese Ausgangssignale korrespondieren jeweils mit dem Lichtstrom, der den jeweiligen Empfangselementen 46 bis 50 zugeführt wird.

Bei Bewegung des Betätigungselements 12 in in den Figuren mit 66 bezeichneter Richtung wird das Auskoppelende 34 des Lichtleiters 30 in Richtung auf das Empfangselement 50 verschwenkt. Entsprechend wird das Auskoppelende 34 des Lichtleiters 30 bei Bewegung des Betätigungselements 12 in einer mit 68 bezeichneten Richtung auf das Empfangselement 46 hin verschwenkt. Die Schaltstellungen, die das Betätigungselement 12 entlang seines Bewegungswegs einnimmt, können dadurch detektiert werden, dass die Empfangselemente 46 bis 50 den jeweils zugeführten Lichtstrom erfassen und analoge Ausgangssignale 60 bis 64 liefern, die von der Auswerteeinheit 58 ausgewertet werden können.

Die Schaltvorrichtung 10 ist mit Bezug auf im Wesentlichen eine Verschwenkrichtung beschrieben worden. Selbstverständlich kann es auch mehrere Verschwenkrichtungen, beispielsweise zueinander senkrechte Verschwenkrichtungen geben oder auch eine Bewegung des Betätigungselements in Längsrichtung, wodurch das Auskoppelende 34 des Lichtleiters 30 in Richtung auf die Empfangselemente 46 bis 50 oder von diesen weg bewegt werden kann.

Bei der in Figur 1 dargestellten Schaltvorrichtung ist die Lichtquelle 28 dauerhaft eingeschaltet. Entsprechend wird an dem Auskoppelende 40 des flexiblen Lichtleiters 38 ein Lichtstrom anliegen, sobald die Lichtquelle 28 eingeschaltet ist. Durch Auswertung des am Auskoppelende 40 anliegenden Lichtstroms mit Hilfe eines Empfangselements kann detektiert werden, ob a) die Lichtquelle 28 funktionsfähig ist und b) welchen Lichtstrom die Lichtquelle 28 liefert. Diese Information kann als Referenz für Lichtströme verwendet werden, die für verschiedene Schaltstellungen des Betätigungselements 12 an den Empfangselementen 46 bis 50 anliegen sollten. Bei Abweichung kann dieses zu erwartende Ausgangssignal entsprechend korrigiert werden.

## Patentansprüche

1. Schaltvorrichtung (10), insbesondere zur Verwendung in Kraftfahrzeugen, mit einem bewegbaren Betätigungselement (12), wobei die Schaltvorrichtung zur Erfassung von Schaltstellungen des Betätigungselements (12) eine Lichtquelle (28) und eine zugeordnete Lichtempfangseinrichtung (42) aufweist, **dadurch gekennzeichnet, dass** die Lichtquelle (28) mit dem Betätigungselement (12) bewegungsgekoppelt ist und dass die Lichtempfangseinrichtung (42) mindestens ein Empfangselement (46, 48, 50) aufweist, das ein von dem zugeführten Lichtstrom abhängiges, analoges Ausgangssignal (60, 62, 64) erzeugt.

2. Schaltvorrichtung (10) nach Anspruch 1, **dadurch gekennzeichnet, dass** die Lichtquelle (28) an oder in dem Betätigungselement (12) angeordnet ist.

3. Schaltvorrichtung (10) nach Anspruch 1 oder 2, **dadurch gekennzeichnet, dass** die Lichtquelle (28) benachbart zu einer Lagerstelle (18) des Betätigungselements (12) angeordnet ist.

4. Schaltvorrichtung (10) nach einem der vorhergehenden Ansprüche, **dadurch gekennzeichnet, dass** die Lichtquelle (28) Licht in einen Lichtleiter (30) speist, der mit dem Betätigungselement (12) bewegungsgekoppelt ist.

5. Schaltvorrichtung (10) nach einem der vorhergehenden Ansprüche, **dadurch gekennzeichnet, dass** die Lichtquelle (28) an oder in einem dem mindestens einen Empfangselement (46, 48, 50) zugewandten Endbereich (36) des Betätigungselements (12) angeordnet ist.

6. Schaltvorrichtung nach einem der vorhergehenden Ansprüche, **dadurch gekennzeichnet, dass** mehrere Empfangselemente (46, 48, 50) mit einer gemeinsamen Auswerteeinheit (58) gekoppelt sind, die die Ausgangssignale (60, 62, 64) der Empfangselemente (46, 48, 50) für eine Bestimmung der Schaltstellung des Betätigungselements (12) auswertet.

7. Schaltvorrichtung (10) Anspruch 6, **dadurch gekennzeichnet, dass** die Auswerteeinheit (58) die Ausgangssignale (60, 62, 64) der Empfangselemente (46, 48, 50) einer Plausibilitätsprüfung unterzieht.
